# EUROPÄISCHE PATENTANMELDUNG

(11) **EP 4 400 846 A2**
(43) Veröffentlichungstag der Anmeldung: **17.07.2024**
(21) Anmeldenummer: 23217475.5
(22) Anmeldetag: 18.12.2023
(51) Int. Cl.: G01R 15/00, G01R 15/09

(54) **SENSORSCHALTUNGSANORDNUNG UND NIEDERSTROMSENSOR MIT BYPASSEINHEIT**

(30) Priorität: 21.12.2022 DE 102022134423
(71) Anmelder: Göpel electronic GmbH, 07745 Jena (DE)
(72) Erfinder: POSCHMANN, Dietmar, 99425 Weimar (DE)
(74) Vertreter: Gleim Petri Patent- und Rechtsanwaltspartnerschaft mbB

(57) **Zusammenfassung**

Die Erfindung betrifft eine Sensorschaltungsanordnung zur kontinuierlichen, analog gesteuerten Weitbereichsmessung eines Messstroms (Idut), die einen Messstromanschluss (DUT), einen Rückstromanschluss (COM), einen Niederstromsensor (LC) mit einem Niederstrom-Messanschluss (ILm) und einem Niederstrom-Bezugsanschluss (ILr), einen Hochstromsensor (HC) mit einem Hochstrom-Messanschluss (IHm) und einem Hochstrom-Bezugsanschluss (IHr) und eine Bypasseinheit umfasst, die von einem Bypass-Steuersignal (Vbp) des Niederstromsensors (LC) gesteuert ist, um einen Überstrom (Ibp), der betragsmäßig außerhalb eines zulässigen Aussteuerbereiches des Niederstromsensors (LC) liegt, mit Hilfe einer Bypasssteuerung (BPC) und eines von der Bypasssteuerung (BPC) analog gesteuerten Bypasstransistors (BPT) von dem Niederstrom-Messanschluss (IIm) des Niederstromsensors (LC) abzuleiten. Um deutlich höhere maximale Dauer-Messströme in beliebiger Stromrichtung zu erreichen, ist der Hochstrom-Bezugsanschluss (IHr) des Hochstromsensors (HC) mit dem Rückstromanschluss (COM) verbunden, der Hochstrom-Messanschluss (IHm) über den Schaltkanal des Bypass-Transistors (BPT) mit dem Messstromanschluss (DUT) verbunden und der Niederstrom-Messanschluss (ILm) des Niederstromsensors (LC) mit dem Messstromanschluss (DUT) verbunden. Ferner betrifft die Erfindung einen Niederstromsensor mit Bypasseinheit.

## Beschreibung

Die Erfindung betrifft eine Sensorschaltungsanordnung zur kontinuierlichen, analog gesteuerten Weitbereichsmessung eines Messstroms, die einen Messstromanschluss, einen Rückstromanschluss, einen Niederstromsensor mit einem Niederstrom-Messanschluss und einem Niederstrom-Bezugsanschluss, einen Hochstromsensor mit einem Hochstrom-Messanschluss und einem Hochstrom-Bezugsanschluss sowie einer Bypasseinheit umfasst, die von einem Bypass-Steuersignal von dem Niederstromsensor gesteuert ist, um einen Überstrom, der betragsmäßig außerhalb eines zulässigen Aussteuerbereiches des Niederstromsensors liegt, mit Hilfe einer Bypasssteuerung und eines von der Bypasssteuerung analog gesteuerten Bypasstransistors von dem Niederstrom-Messanschluss des Niederstromsensors abzuleiten.

Außerdem betrifft die Erfindung einen Niederstromsensor mit Bypasseinheit zur automatischen Messbereichsumschaltung oder zu Ableitung eines Überstroms, wobei der Niederstromsensor einen Ausgang für ein Bypass-Steuersignal aufweist, der einen Messstromanschluss, einen Bezugsstromanschluss und eine vom Bypass-Steuersignal angesteuerte Bypasssteuerung umfasst. Die Bypasssteuerung enthält eine Totzonenschaltung und einen von der Bypasssteuerung angesteuerten Bypasstransistor, dessen Kanal parallel zum Niederstromsensor geschaltet ist. Der Bypasstransistor ist dabei ab Überschreitung eines durch die Totzonenschaltung bestimmten Stromlimits mit einem wachsenden Stromüberschuss zunehmend durchsteuerbar.

An Geräte zur automatischen Messung hoher elektrischer Ströme eines weiten Dynamikbereiches werden hohe Anforderungen gestellt. Das resultiert beispielsweise aus Testanforderungen für elektronische Baugruppen, die in ihrem Betriebsstrom zwischen hohen Arbeitsströmen (100A und mehr) und sehr kleinen Bereitschaftsströmen wechseln. Dabei sind meist verschiedene und teilweise kurzzeitige Betriebs- und Fehlerzustände zu diagnostizieren, deren Größenordnung und zeitliches Auftreten oft unvorhersehbar ist.

Für solche Einsatzfälle sind transiente Störungen, die durch einen Bereichswechsel verursacht werden, unerwünscht. Sie erschweren die sichere und automatisierte Auswertung von fortlaufend registrierten Messwerten und können zur Verdeckung kurzzeitige Prüflingsfehler führen.

Aus diesen Gründen betrifft die Erfindung hauptsächlich die Verbesserung solcher Weitbereichs-Amperemeter, die eine rückwirkungsarme sowie stetig gesteuerte automatische Messbereichsumschaltung besitzen und die sich dadurch für die fortlaufende, ununterbrochene Aufzeichnung elektrischer Ströme eines weiten Dynamikbereiches eignen.

Die Messung großer oder kleiner elektrischer Ströme, eines insgesamt großen Dynamikbereiches, wird üblicherweise mit Stromsensoren unterschiedlicher Empfindlichkeit und mit einer Einrichtung zum Wechsel der Messbereiche bei gleichzeitigem Schutz der Sensoren vor Überlastung realisiert. Zur schnellen Datenerfassung zufälliger Messwerte kommen als Schaltelement üblicherweise Halbleiterbauelemente wie Dioden oder Transistoren zum Einsatz, wobei deren Ansteuerung automatisch erfolgt.

Transistoren reagieren schnell und haben den besonderen Vorteil, dass sie nicht nur digital beziehungsweise diskret angesteuert werden können, sondern zusätzlich auch analog. Hierdurch wird an Stelle einer sprunghaften Änderung, eine stetige Änderung der Einfügungsimpedanz des Amperemeters beim Bereichswechsel möglich. Im Bereich hoher maximaler Dauerströme (über 10A) gibt es nur wenige bekannte Lösungen dieser Art, offenbart zum Beispiel in den Patentschriften US 5,144,154 B2 und US 6,603,301 B2. Sie basieren auf der Verwendung eines Bypasses, der zur Ableitung von Überstrom mit je einem Feldeffekttransistor für jede der erforderlichen Messstromrichtungen ausgestattet ist. Die Erfassung bidirektionaler Ströme, erfordert deshalb ein komplementäres Paar von Feldeffekttransistoren.

Je nach Messstromrichtung wird bei Überschreitung eines zugehörigen Stromlimits vom Niederstrom-Sensor einer der komplementären Transistoren separat mit Hilfe einer Todzonenschaltung aktiviert und bei zunehmendem Strom, demensprechen zunehmend durchgesteuert. Gegenüber einfacheren digital gesteuerten Bereichsautomatiken arbeitet der Bypass beim Ableiten des Überstromes als analoger Regler und schützt zugleich den Niederstromsensor vor Überlastung.

Die Patente US 6,603,301, US 8,143,880 B2 und US 8,115,474 B2 offenbaren entsprechende, einander ähnliche Lösungen, die einen Transimpedanzverstärker als Niederstromsensor mit einem automatisch und analog gesteuerten Bypasstransistor sowie einem, aus Messwiderstand und Instrumentenverstärker bestehenden, Hochstromsensor miteinander kombinieren. Die in der US 8,143,880 B2 offenbarte Lösung ermöglicht ein verbessertes Regelverhalten beim Messbereichswechsel und die US 8,115,474 B2 offenbart als Niederstromsensor eine Mehrbereichslösung mit mehreren in Reihe geschalteten Transimpedanzverstärkern, die jeweils mit einer zugehörigen Bypasseinheit versehen sind. Die benannten Lösungen basieren auf einem Transimpedanzverstärker für den Niederstromsensor, einer zum Transimpedanzverstärker parallel geschalteten, analog regelnden Bypasseinheit und einem im Messstromeingang des Transimpedanzverstärkers zwischengeschalteten Hochstromsensor, welcher vorzugsweise als Messwiderstand mit nachgeschalteten Instrumentenverstärker ausgebildet ist.

Die US 8,143,880 B2 offenbart eine zum Niederstromsensor parallel geschalteten Bypasseinheit, in der für jede Messstromrichtung ein von einer Bypasssteuerung angesteuerter Bypasstransistor enthalten ist. Als Transistortyp werden Metalloxidschicht-Feldeffekttransistoren verwendet. Für bidirektionale Messströme arbeiten zwei Bypasstransistoren unterschiedlichen Leitfähigkeitstyps jeweils in Drain-Schaltung bei normaler Betriebsstromrichtung beziehungsweise als Spannungsfolger.

Die Gate-Steueranschlüsse der Bypasstransistoren werden entweder von einer gemeinsamen oder von zwei getrennten Bypasssteuerungen angesteuert. Die Bypasssteuerungen beinhalteten entsprechend eine doppelte (US 6,603,301 B2) oder zwei getrennte (US 8,143,880 B2) Totzonenschaltungen, mit denen das Signal zum Ansteuern der Bypasstransistoren gebildet wird. Die Totzonengrenze bestimmt jeweils das Stromlimit beziehungsweise den Stromgrenzwert, ab dem der Bereichswechsel beginnt. Totzonenschaltungen sind hierfür in einer Vielzahl von Ausführungsformen bekannt und können mit nichtlinearen Komponenten, wie Dioden, Z-Dioden, begrenzenden Verstärkern oder mit nichtlinearen Verstärker-Dioden-Kombinationen, aufgebaut sein. Ferner können sie einfach oder doppelt ausgeführt sein.

Die erstmals in US 6,603,301 B2 offenbarte Anordnung der Sensoren und des Transistor-Bypasses, beeinträchtigt den Dynamikbereich beziehungsweise die Genauigkeit beider Messbereiche. Da der Hochstromsensor direkt im Strommesspfad des empfindlichen Messstromanschlusses des Strommessgerätes zwischengeschaltet ist und sich somit am Messeingang des Transimpedanzverstärkers befindet, wird die Genauigkeit bei der Niederstrom-Messung durch die beiden Eingangsströme des über den Messwiderstand für hohen Strom angeschlossenen Instrumentenverstärkers oder durch andere Störströme eines Hochstromsensors anderer Bauart beeinträchtigt.

Hat dieser Instrumentenverstärker Eingänge mit Feldeffekttransistoren, dann entsteht nur ein kleiner zusätzlicher Messfehler für den als Transimpedanzverstärker ausgeführten Niederstromsensor, zugleich ist der Messfehler des Hochstromsensors aber um ein Mehrfaches gegenüber Lösungen mit rauscharmen Präzisionsverstärkern erhöht. Zudem kann bei erhöhter Empfindlichkeit des Transimpedanzverstärkers, dessen Genauigkeit immer noch merklich beeinträchtigt sein.

Ein Instrumentenverstärker mit Bipolar-Transistoren im Eingang wäre für den Signalstörabstand des Hochstromsensors zwar gut, jedoch würde das einen weit größeren Messfehler für den Niederstromsensor bewirken. Auch für andere Arten des Hochstromsensors, wie magnetische Stromwandler, besteht die Gefahr von unerwünschten Störsignalen, die auf den Niederstromsensor eingekoppelt werden.

Mit den oben benannten Lösungen sind nur unzureichend hohe Dauerströme messbar. Bei Hochstrommessungen kommt es besonders darauf an, die Leistungsverluste durch einen zu hohen Spannungsabfall im Strommesspfad zu minimieren. Eine Schwachstelle der bisherigen Lösungen ist der Bypass-Schalter, der komplementäre Transistoren für die positive und negative Richtung des Messstromes erfordert. MOSFETs vom P-Kanal Typ haben jedoch erhöhte Schaltgeschwindigkeiten und vor allem vergleichsweise hohe Einschalt-Widerstände. Sie sind weit weniger belastbar als N-Kanal Typen und werden daher nicht für den Bereich besonders hoher Ströme hergestellt.

Daraus ergibt sich die Aufgabe, eine Bypass-Schaltungsanordnung zu schaffen, die auf effektive Art und Weise deutlich höhere maximale Dauer-Messströme in beliebiger Stromrichtung gestattet. Dabei soll der Bypass-Sperrstrom die Genauigkeit des Niederstromsensors jedoch möglichst wenig beeinträchtigen. Ferner soll der Dynamikbereich beziehungsweise die Genauigkeit im Hochstrom- und Niederstrom-Bereich verbessert werden.

Diese Aufgabe wird für die eingangs beschriebene Sensorschaltungsanordnung dadurch gelöst, dass der Hochstrom-Bezugsanschluss des Hochstromsensors mit dem Rückstromanschluss verbunden ist, der Hochstrom-Messanschluss über den Schaltkanal des Bypass-Transistors mit dem Messstromanschluss verbunden ist und der Niederstrom-Messanschluss des Niederstromsensors mit dem Messstromanschluss verbunden ist.

Gegenüber dem Stand der Technik sind in der erfindungsgemäßen Lösung Hochstromsensor und Niederstromsensor bezüglich ihres Anschlusses an den Rückstromanschluss und den Messstromanschluss vertauscht, wobei damit noch nicht bestimmt ist, ob beide Sensoren in Reihe oder parallel geschaltet sind. Mit dem Rückstromanschluss und dem Messstromanschluss wird das die Sensorschaltungsanordnung enthaltende Strommessgerät üblicherweise in eine Test- oder Messapplikation geschaltet. Der Rückstrom Stromanschluss muss nicht immer isoliert zur Verfügung stehen und kann bei Bedarf auch fest an Masse, Erde oder eine programmierbare Spannungsquelle eines komplexeren Testsystems angeschlossen sein. Das Vertauschen der Sensoren ermöglicht eine Erhöhung der Messgenauigkeit für beide Messbereiche. Die Störströme vom Hochstromsensor führen nicht mehr zu einer Beeinträchtigung der Messgenauigkeit des Niederstromsensors. Dadurch kann sowohl der Hochstromsensor als auch der Niederstromsensor in vorteilhafter Weise voneinander unabhängig für hohe Genauigkeit optimiert werden.

In der Schaltungsanordnung der Sensoren und des Bypasses, kann der Hochstromsensor sowie der Niederstromsensor zunächst als Zweipol-Messimpedanz betrachtet werden. Störströme des Hochstromsensors können wahlweise direkt zum Rückstromanschluss oder über die Systemmasse und den Hochstrom-Messanschluss abgeleitet werden. Im letzteren Fall ist zu beachten, dass Störströme in den Hochstrom-Messanschluss von weiteren zugehörigen Schaltungsteilen eingespeist werden können. So können in der Stromversorgung und in Schnittstellenkomponenten zusätzliche Filter- und Isolationsmaßnahmen erforderlich sein. Störströme, die kalibrierbar sind und geringe Driften aufweisen, sind weniger kritisch.

Hochstromsensor und Niederstromsensor können grundsätzlich auf beliebigen Technologien basieren, vorteilhafterweise sind sie jedoch als magnetische Stromwandler oder Messwiderstände ausgebildet, die zusätzlich mit mindestens einem Verstärker kombiniert werden. So kann der Niederstromsensor beispielsweise mit Transimpedanzverstärker, Pufferverstärker oder anderen Funktionen ausgeführt sein. Hochstromsensor und Niederstromsensor können auch als Mehrbereichssensoren ausgebildet sein. Zudem benötigen die Sensorelemente meist einen entkoppelnden Verstärker für ihren Signalausgang.

Ein magnetischer Stromwandler als Hochstromsensor ermöglicht einen niedrigen Spannungsabfall und somit eine kleine Verlustleistung im Messstrompfad des Strommessgerätes. Außerdem ist mit magnetischen Stromwandlern in bestimmten Anwendungen eine geerdete Datenerfassung bei 4-Quadrantenbetrieb des Strommessgerätes möglich. Jedoch ist zu berücksichtigen, dass magnetische Stromwandler in der Regel eine niedrigere Genauigkeit haben.

Um weiterhin uneingeschränkt den Einsatz eines Transimpedanzverstärkers oder auch eines anderen, den Messstrom treibenden Verstärkers für den Niederstromsensor zu ermöglichen, ist eine Auskopplung des durch den Verstärker fließenden Messstromanteils an einen Niederstrom-Bezugsanschluss nötig. Dieser ist daher in einer vorteilhaften Ausgestaltung mit Hilfe einer Signalisolation des Messpfades vom Stromsensor oder mit Hilfe einer galvanisch getrennten Stromversorgung realisiert, welche dazu dient, diesen den Messstrom treibenden Verstärker zu versorgen. Mit der so gebildeten isolierten Stromversorgung wird eine potenzialfreie Systemmasse erzeugt, die dann an den Niederstrom-Bezugsstromanschluss führt.

Gemäß einer weiteren vorteilhaften Ausgestaltung ist der Niederstrom-Bezugsanschluss zwischen dem Hochstrom-Messanschluss und dem Rückstromanschluss angeordnet. Falls es im Messpfad des Hochstromsensors eine Serienschaltung mehrerer Bauelemente oder Sensoren gibt, kann auch ein beliebiger Knoten dieses Pfades beschaltet sein. Der Ort der Verbindung bestimmt, ob die Sensoren bezüglich des Messstromes in Reihe oder parallelgeschaltet sind. So bewirkt eine Verbindung an den Hochstrom-Messanschluss eine Reihenschaltung und eine Verbindung an den Hochstrom-Bezugsanschluss bewirkt dagegen eine Parallelschaltung von Hochstromsensor und Niederstromsensor. Gleichzeitig haben diese Schaltungsvarianten Auswirkungen auf die Unterdrückung verschiedener Störquellen und sollten daher in Abhängigkeit von der Art der Sensoren und ihrer speziellen Eigenschaften ausgewählt sein. So können magnetische Sensoren im Messstrompfad zum Teil relativ hohe Störspannungen erzeugen. Bei einer Sensor-Parallelschaltung wirkt sich diese Störspannung im Niederstrombereich nicht auf die Messgenauigkeit aus. Bei einer Sensor-Reihenschaltung addiert sich die benannte Störspannung zur Versorgungsspannung im Messstromkreis und führt in Verbindung mit einer Last- oder Messkreis-Impedanz zu einer entsprechenden Störung des resultierenden Messstromes. Außerdem entstehen durch diese Verschaltung unterschiedliche Anforderungen an Datenerfassung, Datenverarbeitung und Kalibrierung. So müssen beispielsweise Signale parallel geschalteter Sensoren in der Signalverarbeitung erst skaliert und dann addiert werden, um ein richtiges Messergebnis zu erzielen. Dies ist allgemein bekannt und kann per Hardware oder Software erfolgen. Außerdem kann eine zeitlich simultane Datenerfassung erforderlich werden. Signale seriell geschalteter Sensoren sind etwas einfacher zu handhaben.

Sofern der Niederstromsensor wie oben beschrieben mindestens einen den Messstrom treibenden Verstärker enthält, können wahlweise weitere Anpassungen zur Störunterdrückung und zur Anpassung der Impedanz des Niederstromsensors sowie seiner Einfügungsimpedanz an den Bypass-Widerstand erfolgen. Vorteilhaft ist hier, den Eingang für die Niederstrom-Bezugsspannung des entsprechenden Verstärkers zwischen dem Hochstrom-Messanschluss und dem Rückstromanschluss anzuordnen. Auf diese Weise werden Störungen reduziert, die im Hochstromsensor induziert werden.

Der Dynamikbereich über beide Messbereiche kann vorteilhaft erhöht werden, indem der Niederstromsensor für seinen den Messstrom treibenden Verstärker eine Vorrichtung zur Offsetkorrektur erhält, die der Reduzierung der am Bypasstransistor anliegende Sperrspannung dient und insbesondere Temperatur- und Langzeitdriften ausgleicht. Mit deren Hilfe wird dann die Spannung am gesperrten Kanal des Bypass-Schalters auf näherungsweise null Volt eingestellt beziehungsweise nachgeregelt, um Langzeit- und Temperaturdriften dieser Offsetspannung zu kompensieren. Die als Bypass-Schalter arbeitenden MOSFETs haben am Schaltkanal bei kleinen Sperrspannungen ein näherungsweise ohmsches Verhalten, so dass der einen Messfehler des Niederstromsensors verursachende Sperrstrom auf diese Weise reduziert ist. Für eine Hardwarelösung kann der entsprechende Verstärker mit einem driftarmen Verstärker zur Offsetmessung und einer langsamen integrierenden Regelschaltung kombiniert sein.

Flexibler anpassbar ist eine digitale Lösung, die einen driftarmen Messverstärker sowie einem Analog-Digital-Konverter zur Offsetmessung mit einem drift- und rauscharmen Digital-Analog-Konverter zur Erzeugung eines Kompensationssignales am Eingang für die Niederstrom-Bezugsspannung verwendet. Damit ist es möglich, Korrekturen nur in Phasen niedriger Messströme vorzunehmen und digital bis zur nächsten Korrekturphase konstant zu halten. Dies führt insbesondere zu einem besseren Einschwingverhalten beim plötzlichen Wechsel von großen zu kleinsten Messströmen.

Die Aufgabe wird ferner für den eingangs beschriebenen Niederstromsensor dadurch gelöst, dass die Bypasssteuerung eine bei Überschreiten eines inversen Stromlimits gleichgerichtet durchsteuernde Totzonenschaltung umfasst, so dass der Bypasstransistor bei Überschreitung des inversen Stromlimits durchgesteuert ist. Alternativ oder zusätzlich ist der Bypass-transistor als Feldeffekttransistor ausgebildet, wobei dessen Source-Anschluss an ein Potential des Bezugsstromanschlusses und dessen Drain-Anschluss an ein Potential des Messstromanschlusses geschaltet ist. Eine solche Bypasseinheit ermöglicht insbesondere den normalen, inversen oder bidirektionalen Betrieb des Bypasstransistors, der einen beliebigen Leitfähigkeitstyp aufweist. Damit wird das Messen von deutlich höheren maximalen Strömen bei rückwirkungsarmer, stetig gesteuerter Bereichsumschaltung möglich.

Diese Eigenschaften können weiter verbessert werden, indem die Bypasssteuerung eine bei Überschreiten eines positiven Stromlimits gleichgerichtet durchsteuernde Totzonenschaltung umfasst, so dass der Bypasstransistor bei Überschreitung des positiven Stromlimits durchgesteuert ist.

Damit ist auch das erfindungsgemäße Verhalten der Bypasseinheit beschrieben, welches ähnlich den vorbekannten Lösungen mit verschiedenen technischen Mitteln erzielbar und an verschiedene Einsatzfälle anpassbar ist. Die Einsatzfälle betreffen hauptsächlich die zu unterstützende Stromrichtung, die sich aus den vorgesehenen Betriebsarten des Bypass-Transistors für normalen, inversen oder bidirektionalen Stromfluss ergeben.

Zur Realisierung der erfindungsgemäßen Lösung ist vor allem ein geeigneter Typ für den Bypasstransistor auszuwählen, beispielsweise mit hoher Strombelastbarkeit, niedrigem Einschaltwiderstand und niedrigem Sperrstrom, beispielsweise ein N-Kanal MOSFET. Dieser Bypasstransistor, wird dann nicht mehr nur für eine normale Richtung zu der Ableitung von zu hohen Strömen bei Drain-Schaltung verwendet, sondern wahlweise für jede der möglichen Stromrichtungen. Der Bypasstransistor ist außerdem mehr auf eine Drain-Schaltung beschränkt. Der Fall für eine normale Stromrichtung entspricht der Richtung des Stromes bei normal am Transistor-Kanal anliegender Spannung, die inverse ist ihr entgegengerichtet und der Fall für bidirektionale Ströme vereint die Unterstützung beider Stromrichtungen.

Das grundsätzliche Verhalten des Bypasstransistors ist bei der erfindungsgemäßen Lösung und ihrer Ausführungsbeispiele unabhängig davon, ob er in Drain- oder Source-Schaltung angeschlossen ist. Die mit einer Totzonenschaltung bestimmte Übertragungskennlinie zum Ansteuern des Bypasstransistors hängt dabei lediglich von dessen Kanal-Typ und Gate-Schwellspannung ab. Im Bereich kleiner Sperrspannungen, was bei der Anwendung in Amperemetern gegeben ist, kann ein FET oder MOSFET in beiden Stromrichtungen betrieben und analog beziehungsweise stetig angesteuert werden. Zu beachten sind lediglich die unterschiedlichen Gate-Kanal Kapazitäten, wenn die Schaltung fachmännisch ausgelegt wird. Beispielsweise wird ein typischer N-Kanal MOSFET für beide Stromrichtungen mit einer positiven Gatespannung oberhalb seiner Schwellspannung stetig durchgesteuert.

Zur Realisierung einer Schaltungsanordnung, die das eben beschriebene Verhalten unterstützt, befindet sich vorteilhaft für jede unterstützte Stromrichtung im Signalpfad der Bypasssteuerung, eine Totzonenschaltung, die mit einer weiteren Totzonenschaltung parallelgeschaltet ist, wobei von der Totzonenschaltung und der weiteren Totzonenschaltung ausgegebene Ausgangssignale vorzeichenbehaftet derart addiert sind, dass der Bypass-transistor für beide Richtungen des Überstromes durchgesteuert ist. Beispielsweise können zwei Bypasstransistoren mit ihren Kanälen parallelgeschaltet sein, um beide Gate-Signale für normale und inverse Ableitung von Überstrom zusammenzuführen. Hierfür ist jedes Gate über eine eigene Totzonenschaltung für die entsprechende normale sowie inverse Stromrichtung anzusteuern.

Es lässt sich ein niedrigerer Sperrstrom der Bypasseinheit erzielen, wenn die von der Totzonenschaltung ausgegebenen Signale für beide Stromrichtungen an einer anderen Stelle der Signalkette zusammengeführt sind und nur ein einziger Bypasstransistor für beide Stromrichtungen angesteuert werden muss. Dies ist auch günstiger in Bezug auf Kosten und Bestückungsfläche.

Eine andere bevorzugte Lösung ist, wenn die Totzonenschaltung einen vorgeschalteten Vollwellengleichrichter umfasst. Damit wäre, mit einem einzigen Grenzwert der Totzonenschaltung, das normale und inverse Bereichslimit des Niederstromsensors zugleich festgelegt. Mit der Bypasssteuerung wird somit der gewählte Bypasstransistor-Typ, sowohl in der normal vorgesehenen Stromrichtung bei Überschreitung des normalen Stromlimits als auch in der inversen Stromrichtung bei betragsmäßiger Überschreitung des inversen Stromlimits, durchgesteuert.

Für die oben beschriebene Drain-Schaltung des Bypass-Transistors bedeutet dies beispielsweise, dass er in der inversen Stromrichtung zwar durchgesteuert wird, aber nicht mehr als Spannungsfolger arbeitet. Ein Bypass-Transistor kann jedoch im erfindungsgemäßen Überstrom-Regelkreis für beide Stromrichtungen näherungsweise als spannungsgesteuerte Stromquelle betrachtet werden.

Unter bestimmten Umgebungsbedingungen kann es zu einer Instabilität des Überstrom-Reglers kommen. Hierfür wird üblicherweise eine Anpassung der Frequenzkompensation vorgenommen. Für die beschriebene Bypasssteuerung ist es von Vorteil, die Spannungsanstiegsgeschwindigkeit der Gate-Steuerspannung für den Bypasstransistor mittels einer in der Bypasseinheit enthaltenen Schaltung zu begrenzen. Damit wird insbesondere der unerwünschte und einen Messfehler verursachende kapazitive Strom vom Gate-Treiber des Bypass-Transistors auf den Messstromanschluss begrenzt.

Der Bypass-Transistor kann auch in Source-Schaltung angeschlossen sein. Dies ist eine weitere Maßnahme, um die zuvor beschriebene und teilweise störende kapazitive Kopplung vom Gate-Treiber auf den Messstromanschluss zu reduzieren. Im bisherigen Stand der Technik ist die Verwendung der Source-Schaltung unbekannt. Innerhalb der beschriebenen Sensorschaltungsanordnung ergeben sich Vorteile für die Einschwingzeit des Überstromreglers. Die Einschwingzeit wird durch die parasitäre Kapazität des Bypasstransistors zwischen Gate- und Messstromanschluss beeinträchtigt und ist in Source-Schaltung typischerweise vielfach kleiner.

Vorteilhaft sind mehrere zu dem Bypasstransistor parallel oder antiparallel geschaltete Transistoren vorhanden, welche über die Gate-Spannung durchgesteuert werden und ebenfalls eine Ableitung des Überstroms ermöglichen, um den maximal möglichen Messstrom vom Hochstromsensor zu erhöhen. Der Gate-Treiber ist dann für die erhöhte Gate-Kapazität auszulegen und es ist die Erhöhung des Sperrstromes vom Bypass zu berücksichtigen.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

Nachfolgend wird die Erfindung anhand von Ausführungsbeispielen unter Bezugnahme auf die beigefügten Zeichnungen, die ebenfalls erfindungswesentliche Merkmale offenbaren, noch näher erläutert. Diese Ausführungsbeispiele dienen lediglich der Veranschaulichung und sind nicht als einschränkend auszulegen. Beispielsweise ist eine Beschreibung eines Ausführungsbeispiels mit einer Vielzahl von Elementen oder Komponenten nicht dahingehend auszulegen, dass alle diese Elemente oder Komponenten zur Implementierung notwendig sind. Vielmehr können andere Ausführungsbeispiele auch alternative Elemente und Komponenten, weniger Elemente oder Komponenten oder zusätzliche Elemente oder Komponenten enthalten. Elemente oder Komponenten verschiedener Ausführungsbespiele können miteinander kombiniert werden, sofern nichts Anderes angegeben ist. Modifikationen und Abwandlungen, welche für eines der Ausführungsbeispiele beschrieben werden, können auch auf andere Ausführungsbeispiele anwendbar sein. Zur Vermeidung von Wiederholungen werden gleiche oder einander entsprechende Elemente in verschiedenen Figuren mit gleichen Bezugszeichen bezeichnet und nicht mehrmals erläutert. Es zeigen:
- Fig. 1: das Schaltbild einer Sensorschaltungsanordnung in einem ersten Ausführungs-beispiel,
- Fig. 2: das Schaltbild einer Sensorschaltungsanordnung in einem zweiten Ausführungsbeispiel,
- Fig. 3: das Schaltbild einer Sensorschaltungsanordnung in einem dritten Ausführungsbeispiel und
- Fig. 4: das Schaltbild einer Sensorschaltungsanordnung in einem vierten Ausführungsbeispiel.

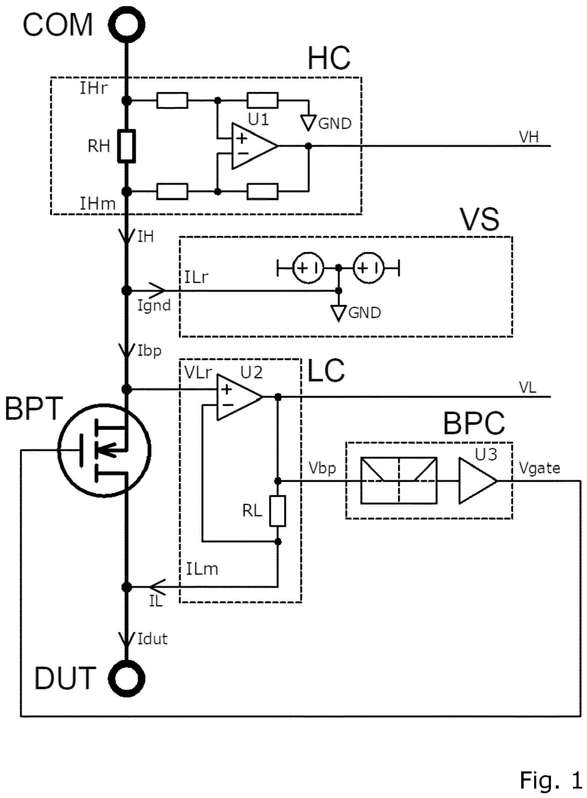

Nachfolgend werden anhand der Fig. 1 bis 4 verschiedene Ausführungsbeispiele mit Realisierungsvarianten zur Sensor-Bypass Schaltungsanordnung beschrieben. Die Varianten betreffen Sensor-Reihenschaltung oder -Parallelschaltung, Sensorbauart und Maßnahmen zur Unterdrückung von Störungen sowie die Anpassung von Einfügungsimpedanzen der Sensoren.

Den in den **Fig. 1 bis 4** gezeigten Ausführungsbeispielen ist gemeinsam, dass sie die Bestandteile eines Amperemeters mit Sensor- und Bereichsautomatik umfassen. Das sind im Einzelnen ein Messstromanschluss DUT, ein Rückstromanschluss COM, eine Systemversorgung VS, ein Niederstromsensor LC, der einen Niederstrom-Bezugsanschluss ILr und einen Niederstrom-Messanschluss IIm aufweist und ein Niederstromsignal VL für eine externe nicht dargestellte Datenerfassungseinheit ausgibt, ein Hochstromsensor HC, der einen Hochstrom-Bezugsanschluss IHr und einen Hochstrom-Messanschluss IHm aufweist und ein Hochstromsignal VH für die Datenerfassungseinheit ausgibt, sowie eine Bypasssteuerung BPC und ein Bypasstransistor BPT. Die letzteren beiden werden zusammen im Folgenden auch als Bypasseinheit bezeichnet. Fett gezeichnet ist ein vom Rückstromanschluss COM zum Messstromanschluss DUT führender Hochstrompfad. Für die Anordnung der vorgenannten Bauteile wird auf die jeweilige Figur verwiesen. Die Systemversorgung VS ist in allen Ausführungsbeispielen von den anderen Komponenten der Sensorschaltungsanordnung galvanisch getrennt ausgebildet.

Die Bypasssteuerung BPC, welche hier aus einer Totzonenschaltung und einem das Bypass-Steuersignal Vbp treibenden Operationsverstärker U3 besteht, bildet mit dem Bypasstransistor BPT und dem Niederstromsensor LC einen autonom arbeitenden analogen Stromregler, der mit Hilfe der in der Bypasssteuerung BPC enthaltenen Totzonenschaltung bei einer positiven oder negativen Überschreitungen des zulässigen Niederstrom-Messbereichs durch ein Bypass-Steuersignal Vbp des Niederstromsensors LC aktiviert wird und dann den Überstrom Ibp über den Kanal, also die Source-Drain-Strecke, des Bypasstransisors BPT ableitet.

Alle Ausführungsbeispiele unterstützen einen weiten Dynamikbereich der eingesetzten Stromsensoren LC, HC und die Messung hoher bidirektionaler Ströme. Letzteres wird mit einer in der Bypasssteuerung BPC enthaltenen, gleichrichtend wirkenden, doppelten Totzonenschaltung erreicht, die sowohl bei zunehmender Überschreitung eines positiven Stromgrenzwertes als auch bei betragsmäßiger Überschreitung eines negativen Stromgrenzwertes für den By-passtransistor BPT eine jeweils zunehmend positive Gate-Spannung Vgate erzeugt. Das ist innerhalb der Bypasssteuerung BPC mit einer stetigen Übertragungsfunktion dargestellt, die die Totzonenschaltung repräsentiert. Die Sensorschaltungsanordnung verhält sich so, dass bei einem aus dem Messstromanschluss DUT herausfließenden Messstrom Idut die Spannungen des Niederstromsignals VL, des Hochstromsignals VH sowie des Bypass-Steuersignals Vbp positiv sind.

In **Fig. 1** sind der Niederstromsensor LC und der Hochstromsensor HC mit ihrem Messstrompfad zwischen dem Messstromanschluss DUT und dem Rückstromanschluss COM in Reihe geschaltet. Die Systemversorgung VS ist hier ein funktioneller Bestandteil des Niederstromsensors LC, um einen Bezugs-Niederstrom Ignd auszukoppeln und den Betrieb der Sensoren HC, LC in Reihenschaltung zu ermöglichen. Der Niederstromsensor LC arbeitet mit einem Niederstrom-Messwiderstand RL und wird mit Hilfe der Bypasssteuerung BPC und des Bypasstransistors BPT automatisch vor zu großen bidirektionalen Messströmen Idut geschützt. Hierzu wird die Bypasssteuerung BPC von einem Bypass-Steuersignal Vbp des Niederstromsensors LC angesteuert und arbeitet beim Überschreiten eines positiven oder negativen Messbereichs-Grenzwertes als analoger, den Bypasstransistor BPT ansteuernder Regler. Innerhalb einer Totzone der in der Bypasssteuerung BPC vorhandenen Totzonenschaltung bleibt der Bypasstransistor BPT gesperrt. Die Messbereichs-Grenzwerte können auch mit Hilfe zweier Totzonenschaltungen innerhalb der Bypasssteuerung BPC festgelegt sein. Für den Bypasstransistor BPT ist hier ein N-Kanal-Metalloxidschicht-Feldeffekttransistor vom selbstsperrenden Anreicherungstyp eingesetzt, der zum Durchsteuern für jede der zwei Stromrichtungen eine positive Gate-Spannung Vgate erhält. So wird nur ein einziger Bypasstransistor BPT und ein einziger Gate-Treiber für eine beliebige Richtung oder für beide Richtungen der Überstromableitung benötigt. Auf einen für diesen Einsatzzweck eher ungeeigneten P-Kanal-Transistor kann auf diese Weise verzichtet werden.

Der Niederstrom-Bezugsanschluss ILr wird mit Hilfe einer galvanisch getrennten Systemversorgung VS gebildet und ist mit dem Hochstrom-Messanschluss IHm verbunden. Die Systemversorgung VS der Messelektronik ist galvanisch getrennt und einschließlich der Bypasssteuerung BPC, mit ihrer Systemmasse GND mit dem Hochstrom-Messanschluss IHm verbunden. Störströme, die in den galvanisch getrennten Schaltungsteil eingekoppelt werden, fließen über den Hochstromsensor HC zum Rückstromanschluss COM und müssen deshalb so klein sein, dass dessen Messgenauigkeit nicht beeinträchtigt ist. Für die galvanisch getrennte Systemversorgung VS eignet sich besonders der Einsatz von Schaltwandlern, die sich mit der Datenerfassung synchronisieren lassen.

Der im Stand der Technik störende Einfluss des Hochstromsensors HC auf den Niederstromsensor LC wird mit der vorgestellten Sensorschaltungsanordnung unterbunden. Die Eingangsruheströme des als Differenzverstärker geschalteten Operationsverstärker U1 fließen zur Systemmasse GND zurück, ohne einen Einfluss auf den Niederstromsensor LC zu haben. Auf die gleiche Weise wird der größte Teil des über den Source-Anschluss des Bypasstransistors BPT fließenden Gate-Stromes an die Systemmasse GND abgeleitet. Nur ein über eine im Bypasstransistor BPT vorhandene Gate-Drain-Kapazität fließender Strom erzeugt unter bestimmten Bedingungen einen Messfehler für den Niederstromsensor LC und ist von der Spannungsanstiegsgeschwindigkeit der Gate-Spannung Vgate des Bypasstransistors BPT abhängig.

Der Hochstromsensor HC ist für einen optimalen Signal-Stör-Abstand, insbesondere bezüglich Rauschen und Offsetdrift zu optimieren. So ist in **Fig. 1** für den Hochstromsensor HC mit einem an ihm vorhandenen Hochstrom-Messwiderstand RH statt eines Instrumentenverstärkers mit FET-Eingängen ein rauschärmerer und driftärmerer Differenzverstärker verwendet. Auf Grund der guten Ableitung von Störströmen sind analoge und digitale Lösungen zur weiteren Reduktion von Offsetdriften ohne nachteilige Nebenwirkungen auf die Genauigkeit des Niederstromsensors LC implementierbar. Diese Prinzipien sind zwar grundsätzlich von Strommessgeräten mit digitaler Bereichsautomatik bekannt, jedoch sind sie bei bisher üblichen Schaltungen nicht ohne Weiteres auf Geräte mit stetig bzw. sprungfrei gesteuerter Bereichsautomatik übertragbar.

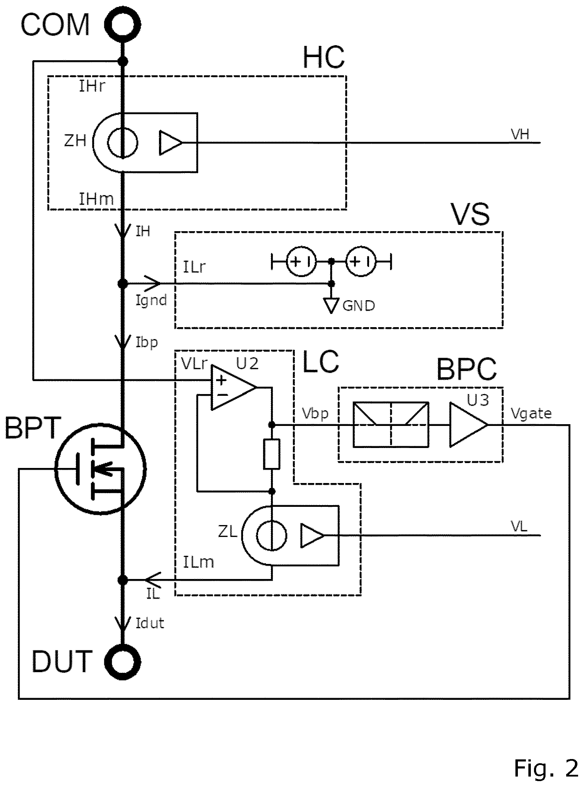

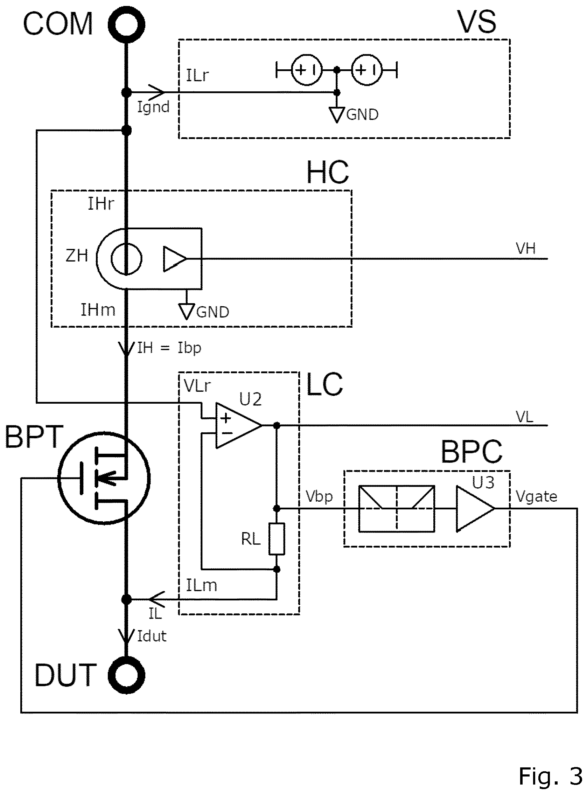

Der Hochstromsensor HC kann, wie in **Fig. 2** **und** **3** abgebildet, auch als magnetischer Stromwandler ausgeführt sein. Mit magnetischen Stromwandlern kann der Spannungsabfall und der Leistungsverlust bei höheren Messströmen reduziert werden. Dies ist vor allem bei Dauerströmen ab etwa 100A relevant. Zudem ist es möglich, einen bereits vorhandenen externen Hochstromsensor HC zu verwenden, beispielsweise den Strommonitor einer separaten Stromversorgungseinheit. Mit dieser Variante werden unnötige Spannungsabfälle und Leistungsverluste in der Gesamt-Anwendung für einen Prüflingstest vermieden. Das verbessert die Dauerbelastbarkeit bei maximalem Messstrom Idut und reduziert zudem die Anforderungen an die Wärmeabfuhr.

Es ist jedoch zu beachten, dass magnetische Präzisions-Stromwandler von ihrer Bauart und von Umgebungsbedingungen abhängige Störspannungen in den Messstrompfad induzieren können und dass diese insbesondere bei niedriger oder kapazitiver Last problematische Störungen des Messstromes Idut für Strommessungen mit großem Dynamikbereich verursachen können. Dieser Effekt ist mit den Modifikationen der Sensorschaltungsanordnung entsprechend den Ausführungsformen nach **Fig. 2** **und** **3** reduzierbar.

In der in **Fig. 2** gezeigten Ausführungsform ist der Eingang der Niederstrom-Bezugsspannung VLr gegenüber **Fig. 1** umgelegt worden und befindet sich nun zwischen dem Rückstromanschluss COM und dem Hochstrom-Bezugsanschluss IHr. Das sichert trotz Reihenschaltung der Stromsensoren HC, LC, dass eine vom Hochstromsensor HC induzierte Störspannung für den Niederstrom-Messbereich unterdrückt wird. Die Lösung eignet sich wiederum besonders für Hochstromsensoren HC mit magnetischem Stromwandler. Zudem ist beispielhaft dargestellt, dass der Bypasstransistor BPT auch in Drain-Schaltung betrieben werden kann. Dafür ist lediglich die Frequenzkompensation anzupassen, was zu einem langsameren Bereichswechsel führt. Ein Einbringen des Bypasstransistors BPT in Source-Schaltung ist aber auch hier problemlos möglich.

Im Ausführungsbeispiel wird eine Lösung gezeigt, in der beide Stromsensoren LC, HC magnetische Stromwandler enthalten. Damit wird eine durch den Hochstromsensor HC induzierte Störspannung für den Messbereich des Niederstromsensors LC trotz Reihenschaltung unterdrückt. Zudem ist beispielhaft dargestellt, dass der Bypasstransistor BPT auch in Drain-Schaltung betrieben werden kann. Dazu ist die Frequenzkompensation anzupassen, was jedoch zu einem langsameren Bereichswechsel führt. Die Source-Schaltung, wie sie in den anderen Abbildungen dargestellt ist, ist aber grundsätzlich günstiger und auch hier möglich.

In der **Fig. 2** sind beide Stromsensoren LC, HC mit magnetischen Stromwandlern ausgestattet, einer Niederstrom-Messimpedanz ZL und einer Hochstrom-Messimpedanz ZH. Für den Niederstromsensor LC wird damit zwar nicht mehr der hohe Dynamikbereich eines Transimpedanzverstärkers erreicht, jedoch sind beide Messsignale galvanisch getrennt und können einer geerdeten Messwerterfassung zugeführt werden. Die so gestaltete Lösung eignet sich besonders für Testanwendungen zur Messung in mehreren Strompfaden bei hohen Gleich- oder Wechsel-Spannungen.

Der Operationsverstärker U2 puffert die Bezugsspannung für die Niederstrom-Messimpedanz ZL des Niederstromsensors LC. Er hat, ebenso wie der Operationsverstärker U2 in Fig. 1, die Funktion des Messstroms Idut treibenden Verstärkers. Ein Niederstrom IL des Niederstromsensors LC wird an der Systemmasse GND ausgekoppelt und fließt über den Niederstrom-Bezugsanschluss ILr und den Hochstrom-Messanschluss IHm. Somit sind beide Stromsensoren LC, HC bezüglich ihres Stromflusses, wie im vorherigen Beispiel gemäß Fig. 1, in Reihe geschaltet.

Abweichend dazu ist der Eingang für die Niederstrom-Bezugsspannung VLr an den Rückstromanschluss COM geschaltet. Da dieser Eingang ein Messeingang ist, wirkt diese Maßnahme so, als wäre die Niederstrom-Messimpedanz ZL des Niederstromsensors LC nicht an die Systemmasse GND geschaltet, sondern an den Rückstromanschluss COM. Dadurch können Störungen, die in der Hochstrom-Messimpedanz ZH des Hochstromsensors HC entstehen, nicht direkt auf den Niederstromsensor LC wirken. Ursachen induzierter Störspannungen können hierbei die Modulation eines Flux-Gate-Sensors, eine Entmagnetisierungs-Sequenz im Sensor oder magnetische Störfelder der Umgebung sein.

Die mit dem Hochstromsensor HC induzierten Störungen, werden mit der Betriebsspannungsunterdrückung des Operationsverstärkers U2 unterdrückt. Das ist eine deutliche Verbesserung zum Ausführungsbeispiel nach **Fig. 1****.** Bei hohen Messbandbreiten ist es jedoch nicht immer einfach, eine hinreichend hohe Störunterdrückung zu erzielen. In diesen Fällen ermöglicht das nachfolgend beschriebene und in **Fig. 3** abgebildete Ausführungsbeispiel mit parallelgeschalteten Stromsensoren LC, HC eine weitere Verbesserung.

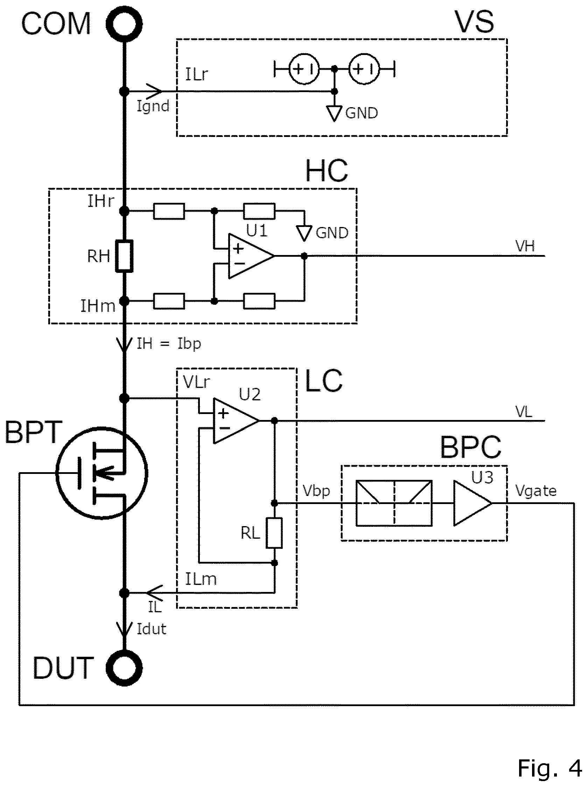

In einer dritten und einer vierten Ausführungsform, die in **Fig. 3** **und** **4** dargestellt sind, ist wieder der Niederstromsensor LC mit dem den Messstrom Idut treibenden Operationsverstärker U2 enthalten, der als Transimpedanzverstärker arbeitet. Der damit gebildete Niederstromsensor LC ist bezüglich seines Strompfades mit sowohl dem Hochstromsensor HC als auch dem Bypasstransistor BPT parallelgeschaltet, indem die Systemmasse GND, die hier auch den Niederstrom-Bezugsanschluss ILr bildet, mit dem Hochstrom-Bezugsanschluss IHr verbunden ist. Gegenüber den vorher beschriebenen Ausführungsformen, vermindert sich ein zum Hochstromsensor HC fließender Hochstrom IH um den durch den Niederstromsensor LC fließenden Niederstrom IL. Der Messstrom Idut im Hochstrombereich ergibt sich daher aus der Summe der Strommesswerte beider Sensoren LC, HC, die hierfür entsprechend skaliert sein müssen.

Der Niederstrom-Bezugsanschluss ILr ist in **Fig. 3** mit dem Hochstrom-Bezugsanschluss IHr sowie mit dem Rückstromanschluss COM verbunden. Die Messanschlüsse ILm, IHm beider Stromsensoren LC, HC sind idealerweise fast frei von Störströmen des jeweils anderen Stromsensors LC, HC sowie der Systemversorgung VS. Im Messpfad des Hochstromsensors HC induzierte Störspannungen werden innerhalb des Niederstrom-Messbereiches lediglich über die relativ kleine Source-Drain-Kapazität des gesperrten Bypasstransistors BPT auf den Messstromanschluss DUT übertragen. Daher eignet sich diese Lösung für hohe Anforderungen an die Niederstrom-Messung, wobei zugleich Anforderungen zur Messung hoher Ströme mit einem magnetischen Präzisionssensor bestehen können.

Für die Messbereichsbestimmung und Datenerfassung sind weitere Anpassungen erforderlich. Im Hochstrom-Messbereich entspricht bei parallelen Stromsensoren LC, HC der richtige Messstromwert der Summe der erfassten Messwerte von Niederstromsensor LC und Hochstromsensor HC. Der Hochstromsensor HC bleibt im Totzonenbereich der Bypasssteuerung BPC ohne Messstrom Idut, was nebenläufig für eine einfache, vorzugsweise digitale und automatische Offsetkorrektur in der Phase von Niederstrommessungen nutzbar ist.

Zudem ist zu beachten, dass die parallelen Strompfade von Niederstromsensor LC und Bypasstransistor BPT ein bestimmtes Verhältnis ihrer Leitwerte haben müssen, um den Überstrom Ibp über den Bypasstransistor BPT bestmöglich ableiten zu können. Deshalb empfiehlt es sich, bei dieser Ausführungsform für den Hochstromsensor HC einen magnetischen Stromwandler einzusetzen. Das hat zur Folge, dass die Einfügungsimpedanz des Niederstromsensors LC nicht unnötig hoch sein muss.

In der **Fig. 4** ist im Hochstromsensor HC ein Hochstrom-Messwiderstand RH eingesetzt, was eine relativ hohe Impedanz im Bypass-Pfad bewirkt und in nachteiliger Weise eine erhöhte Einfügungsimpedanz des Niederstromsensors LC erfordern würde. Dies wird vermieden, indem der Eingang der Niederstrom-Bezugsspannung VLr wie in **Fig. 1** beschaltet ist. Damit wirkt die Einfügungsimpedanz des Niederstromsensors LC so, als wäre sie zum Schaltkanal des Bypasstransistors BPT parallelgeschaltet. Trotzdem bleibt die Parallelschaltung der Stromsensoren LC, HC erhalten. Störströme der Systemversorgung VS und peripherer Schnittstellen werden direkt zum Rückstromanschluss COM abgeleitet und erzeugen keine Messfehler. Jedoch ist zu beachten, dass der Hochstromsensor HC möglichst keine Störspannung induziert, weil diese Störspannung über den Operationsverstärker U2 auf den Messstromanschluss DUT übertragen wird. Mit dem hier resistiven Hochstromsensor HC ist das aber kein Problem.

### Bezugszeichenliste

- DUT: Messstromanschluss
- COM: Rückstromanschluss
- GND: Systemmasse
- VS: Systemversorgung
- LC: Niederstromsensor
- HC: Hochstromsensor
- VL: Niederstromsignal
- VH: Hochstromsignal
- BPC: Bypasssteuerung
- BPT: Bypasstransistor
- RH: Hochstrom-Messwiderstand
- RL: Niederstrom-Messwiderstand
- ZH: Hochstrom-Messimpedanz
- ZL: Niederstrom-Messimpedanz
- Idut: Messstrom
- Vbp: Bypass-Steuersignal
- Vgate: Gate-Spannung
- ILr: Niederstrom-Bezugsanschluss
- IHr: Hochstrom-Bezugsanschluss
- ILm: Niederstrom-Messanschluss
- IHm: Hochstrom-Messanschluss
- VLr: Niederstrom-Bezugsspannung
- U1, U2, U3: Operationsverstärker
- IL: Niederstrom
- IH: Hochstrom
- Ignd: Bezugs-Niederstrom
- Ibp: Überstrom

## Patentansprüche

1. Sensorschaltungsanordnung zur kontinuierlichen, analog gesteuerten Weitbereichsmessung eines Messstroms (Idut), umfassend
- einen Messstromanschluss (DUT),
- einen Rückstromanschluss (COM),
- einen Niederstromsensor (LC) mit einem Niederstrom-Messanschluss (ILm) und einem Niederstrom-Bezugsanschluss (ILr),
- einen Hochstromsensor (HC) mit einem Hochstrom-Messanschluss (IHm) und einem Hochstrom-Bezugsanschluss (IHr) und
- eine Bypasseinheit, die von einem Bypass-Steuersignal (Vbp) des Niederstromsensors (LC) gesteuert ist, um einen Überstrom (Ibp), der betragsmäßig außerhalb eines zulässigen Aussteuerbereiches des Niederstromsensors (LC) liegt, mit Hilfe einer Bypasssteuerung (BPC) und eines von der Bypasssteuerung (BPC) analog gesteuerten Bypasstransistors (BPT) von dem Niederstrom-Messanschluss (IIm) des Niederstromsensors (LC) abzuleiten,
**dadurch gekennzeichnet, dass**
- der Hochstrom-Bezugsanschluss (IHr) des Hochstromsensors (HC) mit dem Rückstromanschluss (COM) verbunden ist,
- der Hochstrom-Messanschluss (IHm) über den Schaltkanal des Bypass-Transistors (BPT) mit dem Messstromanschluss (DUT) verbunden ist und
- der Niederstrom-Messanschluss (ILm) des Niederstromsensors (LC) mit dem Messstromanschluss (DUT) verbunden ist.

2. Sensorschaltungsanordnung nach Anspruch 1, **dadurch gekennzeichnet, dass** der Niederstromsensors (LC) sowie der Hochstromsensor (HC) mit einem Messwiderstand (RL, RH) oder einem magnetischen Stromwandler (ZL, ZH) ausgebildet sind und zusätzlich mit mindestens einem Verstärker kombiniert sind.

3. Sensorschaltungsanordnung nach Anspruch 1 oder 2, **dadurch gekennzeichnet, dass** der Niederstromsensor (LC)
- eine Niederstrom-Messimpedanz (ZL) und/oder
- eine galvanisch getrennte Systemversorgung (VS) für einen den Messstrom (Idut) treibenden Verstärker aufweist.

4. Sensorschaltungsanordnung nach Anspruch 1 bis 3, **dadurch gekennzeichnet, dass** der Niederstrom-Bezugsanschluss (ILr) zwischen dem Hochstrom-Messanschluss (IHm) und dem Rückstromanschluss (COM) angeordnet ist.

5. Sensorschaltungsanordnung nach Anspruch 2 bis 4, **dadurch gekennzeichnet, dass** der dem Niederstrom-Bezugsanschluss (ILr) zugehörige Eingang für die Niederstrom-Bezugsspannung (VLr) des den Messstrom (Idut) treibenden Verstärkers zwischen dem Hochstrom-Messanschluss (IHm) und dem Rückstromanschluss (COM) angeordnet ist.

6. Sensorschaltungsanordnung nach Anspruch 2 bis 5, **dadurch gekennzeichnet, dass** einem den Messstrom (Idut) treibenden Verstärker des Niederstromsensors (LC) eine Vorrichtung zur Offsetspannungskorrektur zugeschaltet ist.

7. Niederstromsensor mit Bypasseinheit zur automatischen Messbereichsumschaltung oder zu Ableitung eines Überstroms (Ibp), wobei der Niederstromsensor (LC) einen Ausgang für ein Bypass-Steuersignal (Vbp) aufweist, umfassend
- einen Messstromanschluss (DUT),
- einen Bezugsstromanschluss (COM),
- eine vom Bypass-Steuersignal (Vbp) angesteuerte Bypasssteuerung (BPC), die eine Totzonenschaltung und einen von der Bypasssteuerung (BPC) angesteuerten Bypasstransistor (BPT) enthält, dessen Kanal parallel zum Niederstromsensor (LC) geschaltet ist,
- wobei der Bypasstransistor (BPT) ab Überschreitung eines durch die Totzonenschaltung bestimmten Stromlimits mit einem wachsenden Stromüberschuss zunehmend durchsteuerbar ist,
**dadurch gekennzeichnet, dass**
A. die Bypasssteuerung (BPC) eine bei Überschreiten eines inversen Stromlimits gleichgerichtet durchsteuernde Totzonenschaltung umfasst, so dass der Bypasstransistor (BPT) bei Überschreitung des inversen Stromlimits durchgesteuert ist, und/oder
B. der Bypasstransistor (BPT) als Feldeffekttransistor ausgebildet ist, wobei dessen Source-Anschluss an ein Potential des Bezugsstromanschlusses (COM) und dessen Drain-Anschluss an ein Potential des Messstromanschlusses (DUT) geschaltet ist.

8. Niederstromsensor gemäß Anspruch 7, **dadurch gekennzeichnet, dass** die Bypasssteuerung (BPC) eine bei Überschreiten eines positiven Stromlimits gleichgerichtet durchsteuernde Totzonenschaltung umfasst, so dass der Bypasstransistor (BPT) bei Überschreitung des positiven Stromlimits durchgesteuert ist.

9. Niederstromsensor nach Anspruch 7 oder 8, **dadurch gekennzeichnet, dass** die Totzonenschaltung zur Ableitung sowohl eines ein negatives als auch eines ein positives Stromlimit übersteigenden Überstromes (Ibp)
- einen vorgeschalteten Vollwellengleichrichter umfasst oder
- die Totzonenschaltung mit einer weiteren Totzonenschaltung parallelgeschaltet ist, wobei von der Totzonenschaltung und der weiteren Totzonenschaltung ausgegebene Ausgangssignale vorzeichenbehaftet derart addiert sind, dass der Bypass-transistor (BPT) für beide Richtungen des Überstromes (Ibp) durchgesteuert ist.

10. Niederstromsensor nach einem der Ansprüche 7 bis 9, **dadurch gekennzeichnet, dass** mehrere zu dem Bypasstransistor (BPT) parallel oder antiparallel geschaltete Transistoren vorhanden sind, welche über die Gate-Spannung (Vgate) durchgesteuert werden und ebenfalls eine Ableitung des Überstroms (Ibp) ermöglichen.
